(19) **Europäisches Patentamt / European Patent Office / Office européen des brevets**

(11) **EP 2 045 620 B1**

(12) **EUROPEAN PATENT SPECIFICATION**

(45) Date of publication and mention of the grant of the patent:
**12.08.2015 Bulletin 2015/33**

(51) Int Cl.:
**G01S 11/14** *(2006.01)*    **H03G 3/32** *(2006.01)*

(21) Application number: **07018982.4**

(22) Date of filing: **26.09.2007**

(54) **Acoustic propagation delay measurement**

Messung der akustischen Laufzeit

Mesure de temps de propagation acoustique

(84) Designated Contracting States:
**AT BE BG CH CY CZ DE DK EE ES FI FR GB GR HU IE IS IT LI LT LU LV MC MT NL PL PT RO SE SI SK TR**

(43) Date of publication of application:
**08.04.2009 Bulletin 2009/15**

(73) Proprietor: **Harman Becker Automotive Systems GmbH**
**76307 Karlsbad (DE)**

(72) Inventors:
• **Christoph, Markus**
**94315 Straubing (DE)**
• **Scholz, Leander**
**94330 Salching (DE)**
• **Wolf, Florian**
**93047 Regensburg (DE)**

(74) Representative: **Westphal, Mussgnug & Partner Patentanwälte mbB**
**Herzog-Wilhelm-Strasse 26**
**80331 München (DE)**

(56) References cited:
**EP-A- 1 720 249        WO-A-2006/014344**
**WO-A-2006/131893**

• **GIROD L ET AL: "Robust range estimation using acoustic and multimodal sensing", PROCEEDINGS OF THE 2001 IEEE/RSJ INTERNATIONAL CONFERENCE ON INTELLIGENT ROBOTS AND SYSTEMS. (IROS 2001). MAUI, HAWAII, OCT. 29 - NOV. 3, 2001; [IEEE/RSJ INTERNATIONAL CONFERENCE ON INTELLIGENT ROBOTS AND SYSTEMS], NEW YORK, NY : IEEE, US, vol. 3, 29 October 2001 (2001-10-29), pages 1312-1320, XP010573757, DOI: 10.1109/IROS.2001.977164 ISBN: 978-0-7803-6612-1**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

BACKGROUND

1. Technical Field

The invention relates to a method for acoustic propagation delay measurement and in particular for acoustic distance measurement by measuring the propagation time of acoustic signals, particularly in strongly reflective rooms in which the noise signals that may arise are reflections of the direct sound wave to evaluate and which may correlate with this signal.

2. Related Art

Acoustic waves traveling in gaseous media, such as air, propagate with a finite velocity. This sonic speed in gases varies with parameters, such as density, pressure and temperature of the gas. With the exception of sound waves of very large amplitude or so-called shock waves, the following approximation is generally used in modern acoustic technology to define the speed of sound, c:

$$c = (331.5 + 0.6 \cdot T[°C]) \ m/s$$

where T is the temperature in degrees of Celsius. This approximation applies to a temperature range from -20°C to +40°C with an accuracy of greater than 0.2% and is therefore considered to be sufficiently precise for applications such as acoustic distance measurements. For a temperature of 20°C, typically assumed as a standard ambient temperature (or room temperature), a value of 343 m/s for c is generally used.

When an acoustic signal is transmitted, for example, from a loudspeaker to a sensor - a microphone, for instance - the time required for the signal to travel this path is measured and the distance between the objects can be accurately derived from the signal's propagation time and the sonic speed. A system and method for determining a distance between two objects based on the acoustic propagation delay is for example known from publication WO 2006/014344 A2. Other aspects of audio signal processing are covered by publication EP 1 720 249 A1. However, in real environmental conditions, in addition to an acoustic direct sound wave of this kind, noise signals and reflections also occur during the propagation time or distance measurement. Noise signals, for example, background noise, and/or reflections can have unwanted effects or corrupt the measurement results.

Accordingly, there is a need for systems and methods that allow for a proper measurement of the propagation delay in particular in noisy and/or strongly reflective rooms.

SUMMARY

A novel system for measuring the acoustic propagation delay from an acoustic transmitter to an acoustic receiver in a room, which together form a transmitter-room-receiver system, comprises: a signal source that is coupled to the acoustic transmitter and supplies a forward signal thereto, the acoustic transmitter emitting an acoustic signal;an impulse response calculation unit configured to estimate the impulse response of the transmitter-room-receiver system from a measuring signal provided by the acoustic receiver and from the forward signal, the measuring signal representing a superposition of the acoustic signal, echoes thereof and noise; and a delay time calculation unit coupled to the impulse response calculation unit and configured to calculate the acoustic propagation delay from the estimated impulse response, the acoustic propagation delay being calculated from the time when the impulse response exceeds a threshold for the first time.

To use the above system in a system that measures the distance between an acoustic transmitter and an acoustic receiver, additionally a distance calculation unit adapted for calculating the distance between the acoustic transmitter and the acoustic receiver from the acoustic propagation delay and the speed of sound is provided.

A novel method for measuring the acoustic propagation delay from an acoustic transmitter to an acoustic receiver in a room, which form a transmitter-room-receiver system, comprises the steps of: providing a forward signal to the acoustic transmitter thus radiating an acoustic signal; generating a measuring signal by the acoustic receiver, the measuring signal being a superposition of the acoustic signal, echoes thereof, and noise; estimating an impulse response of the transmitter-room-receiver system from the measuring signal and from the forward signal; calculating the propagation delay from the estimated impulse response, wherein the propagation delay is calculated from the time when the impulse response exceeds a threshold for the first time.

Using the above method to measure the distance between an acoustic transmitter and an acoustic receiver, the method comprises the additional step of calculating the distance between the acoustic transmitter and the acoustic receiver from the acoustic propagation delay and the speed of sound.

BRIEF DESCRIPTION OF THE DRAWINGS

These and other objects, features, and advantages of the present invention will become apparent in light of the drawings and detailed description of the present invention provided below.

FIG. 1 is a block diagram of a system for measuring the propagation delay from an acoustic transmitter to an acoustic receiver;

FIG. 2 is a timing diagram of an impulse response of a microphone-room-loudspeaker system comprising a strongly reflective room;

FIG. 3 is a block diagram of a system for approximation of an unknown system using an adaptive filter;

FIG. 4 is a block diagram of the system of FIG. 1 where the estimation of the impulse response of the microphone-room-loudspeaker system is performed by employing an LMS adaptive filter;

FIG. 5 is a block diagram of the system of FIG. 4 where an additional delay line is connected downstream to the microphone and a SNR calculation unit is connected upstream to the delay time calculation unit;

FIG. 6 is a block diagram of the system of FIG. 5 with an additional step size calculation for the LMS adaptive filter; and

FIG. 7 is a block diagram of the system of FIG. 6 with an additional automatic gain control system.

DETAILED DESCRIPTION

In contrast to spatial sound waves, the term "direct sound wave" in acoustic technology refers to the sonic wave in a closed room that is first to be received at the point of measurement without suffering sonic reflections on its travel path. The arrival of the initial wave front as direct sound waves is the key to measure the distance traveled. To measure the distance of an object from the sonic source of the measured signal, the use of the so-called cross-correlation function (CCF) with subsequent maximum searching in the evaluation of the direct sound wave may be used.

To avoid faulty measurements, suitable measures must be taken against the susceptibility to uncorrelated noise of this method. One such measure is to repeat the measurement a number of times and to evaluate the results obtained in each case with a median filter. Possible measurement errors characterized by their deviation from the average propagation time can be safely detected in this case and then removed from the full set of measurements. Even if uncorrelated noise signals occur simultaneously, such as ambient noise independent of the measured signal, reliable measurement results can nonetheless be obtained.

The above method cannot be used reliably in strongly reflective rooms. However, noise signals are not only brought about by environmental noises but at least in part from reflections of the direct sound wave, and are therefore also correlated with that direct sound signal. The maximum value of the CCF in this case, therefore, generally no longer necessarily represents the energy and propagation of the direct sound wave for the distance measurement, but the maximum value of the superposition of the direct sound wave with its reflections.

This means that the maximum CCF value no longer reliably corresponds to the arrival of the first wave front of the direct sound wave needed for the evaluation, but rather, for example, can occur later thereby falsifying the measurement result. It is evident that the application of the above method to acoustic distance measurements in strongly reflective rooms, such as the interior of vehicles, does not yield the desired results.

In the following description time dependent discrete time scalar signals, for example a signal x, is denoted as $x[k]$ with k being the time index. Non-scalar signals such as a time variant (finite) impulse response h is denoted as $h_n[k]$ (with $n \in \{0, 1, ..., N-1\}$). This means that the impulse response $h_n[k]$ is regarded as a vector of length N having the time-variant scalar elements $h_n[k] = (h_0[k], h_1[k], ..., h_{N-1}[k])$ with k as time index.

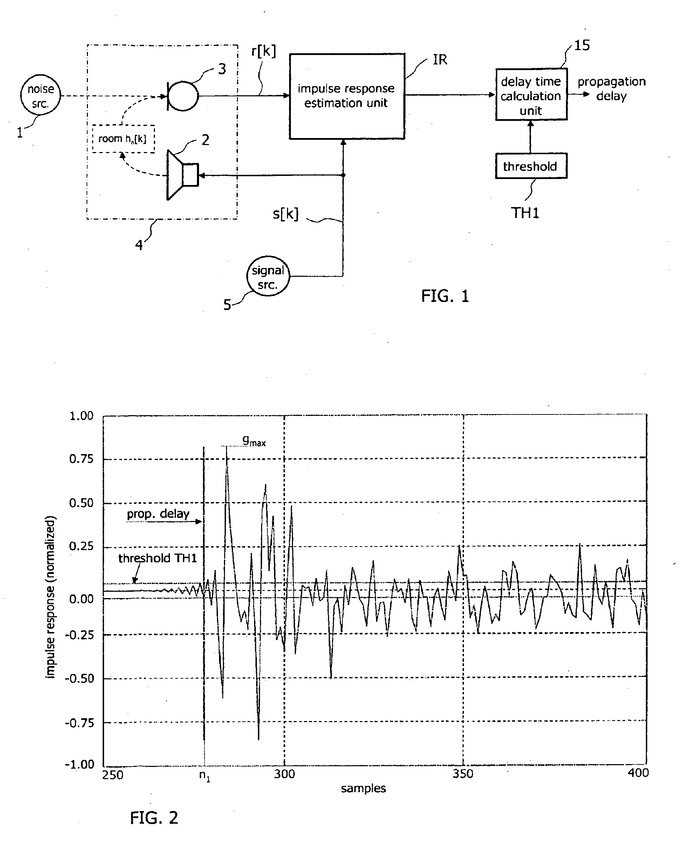

FIG. 1 illustrates an exemplary system for measuring the acoustic propagation delay from an acoustic transmitter (e.g. a loudspeaker 2) to an acoustic receiver (e.g. a microphone 3) which form a transmitter-room-receiver system 4 also referred to as loudspeaker-room-microphone system (LRM system). A signal source 5 is coupled to the loudspeaker 2 for supplying a forward signal $s[k]$ thereto, thus an acoustic signal is radiated from the loudspeaker 2. In the description below, all signals, for example the forward signal $s[k]$, are denoted as discrete time signal with k as time index. Of course analog components as the loudspeaker 2 and the microphone 3 require digital-to-analog and analog-to-digital converters, respectively, which are not shown in the figures for the sake of simplicity.

The microphone receives a superposition of the radiated acoustic signal, reflections thereof, and noise (stemming from a noise source 1) and generates a measuring signal r[k] representing the above-mentioned superposed signal. The impulse response $h_n = [h_0, h_1, ..., h_{N-1}]$ of the transmitter-room-receiver system 4 is estimated by an impulse response calculation unit IR that is configured to estimate the desired impulse response $h_n$ from the measuring signal r[k] and from the forward signal s[k]. Due to the above-mentioned reflections and due to uncorrelated noise which is always present in the measuring signal r[k] the impulse response calculated by the impulse response calculation unit IR is always only an approximation (so called "estimation") of the "real" impulse response of the LRM system. The impulse response may vary over time. To express this, the time index k may be appended to $h_n$ yielding $h_n[k]$. The estimated impulse response is denoted as $g_n[k]$ which is approximately equal to the real impulse response $h_n[k]$ of the LRM system.

The propagation delay, that is the time necessary for the acoustic signal radiated by loudspeaker 2 to reach the microphone 3, is calculated by a delay time calculation unit that is configured to calculate the acoustic propagation delay from the estimated impulse response $g_n[k]$. More precisely, the acoustic propagation delay is calculated from the time $t_1$ when the impulse response exceeds a certain threshold TH1 for the first time. This means, not the absolute maximum value is the relevant measure for the propagation delay but the time $t_1$ of the first sample of the estimated impulse response $g_n[k]$ significantly different from zero. Whether the magnitude of a sample is "significantly different from zero" is in practice decided with the help of a threshold level (e.g. about 5% of the absolute maximum of the impulse response); any samples with a magnitude greater than the threshold level are regarded as significantly different from zero.

FIG. 2 illustrates a typical estimated impulse response $g_n[k]$ of an exemplary LRM system 4 derived from real measurement data. From the fact that it is not the highest peak (with a maximum $g_{MAX}$) of the estimated impulse response $g_n[k]$ that exceeds the threshold level TH1 for the first time, can be concluded that reflections (echoes) are present in the impulse response $g_n[k]$. These reflections can be interpreted as correlated noise and the maximum peak is "shifted" to the right. In contrast to conventional methods, it is not the absolute maximum $g_{MAX}$ of the impulse response which is used as a measured value for the delay time (time lag) of the LRM-system (i.e. the propagation delay of the acoustic signal), but time $t_1$ (respectively the corresponding index $n_1$) of the first sample $g_{n1}[k]$ that is significantly different from zero is used to determine the desired propagation delay. In the present example, time $t_1$ stands for the time upon which the absolute value of the impulse response $|g_{n1}[k]|$ exceeds the threshold level TH1 for the first time.

The impulse response is, e.g., the output signal of a linear, one-dimensional, and time-invariant system receiving a Dirac impulse at its input. The (ideal) Dirac impulse is therefore favored for theoretical analysis because it has an infinite number of frequency components - i.e., a large amplitude frequency spectrum. In contrast, experimental analysis may employ systems where a step function - the step response - is measured which also fully defines the transfer behavior of a system of this kind.

The impulse response of an unknown system can be determined, for example, using the Maximum Likelihood method. Alternative methods include the formation of the CCF by recursive integration and the use of so-called correlation receptors, obtained for example from the use of Maximum Length Sequences (MLS) and, for example, a fast Hadamard transformation. All methods discussed above refer to non-iterative procedures to obtain the greatest possible approximation for the impulse response of an unknown system through a series of calculation steps. Either a fixed time value or a fixed number of samples is used to obtain the desired value, or an average value is calculated for different individual measurements. An adaptive, respectively an iterative adjustment of the approximation of the impulse response in an ongoing individual measurement, for example, in response to dynamically changing properties of the system to measure, is therefore not possible with known methods.

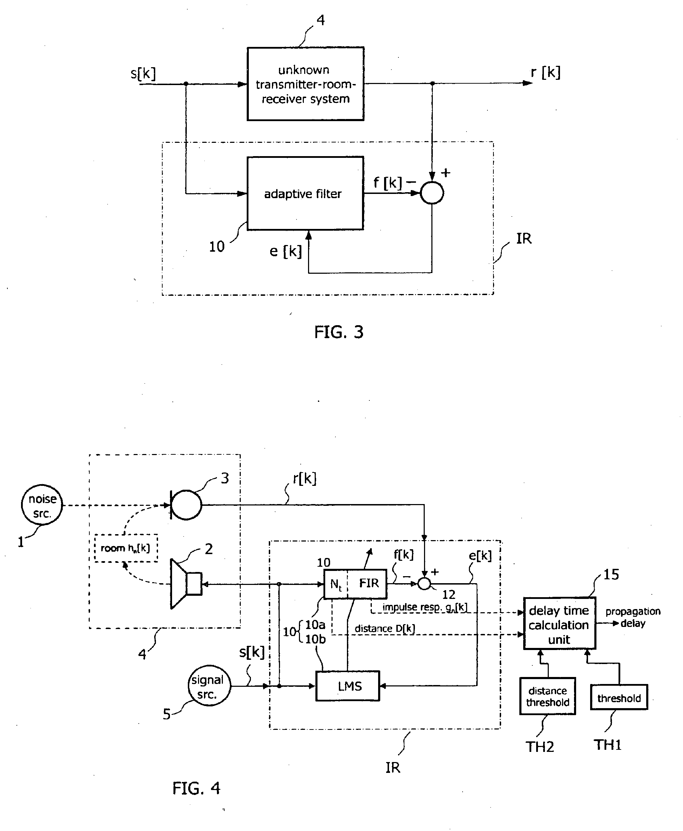

FIGs. 3 to 7 illustrate the estimation of the impulse response $h_n[k]$ of the LRM system by employing an adaptive filter for an iterative approximation of the impulse response. An adaptive filter is a filter which self-adjusts its transfer function according to an optimizing algorithm. Because of the complexity of the optimizing algorithms, most adaptive filters are digital filters that perform digital signal processing and adapt their performance based on the input signal. In contrast, a non-adaptive filter has static filter coefficients which collectively form the transfer function. For some applications, adaptive coefficients are required, since some parameters of the desired impulse response are not known in advance or may (slowly) change with time. In these situations an adaptive filter may be employed, which uses feedback to refine the values of the filter coefficients and hence its frequency response.

Generally speaking, the adaptation process involves the use of a cost function. A reference signal may be used for defining a criterion for optimum performance of the filter such as, for example, minimizing the noise component of the input, to feed an algorithm which determines how to modify the filter coefficients in order to minimize the cost function on the next iteration. Accordingly, adaptive filters can be used, for example, in a recursive process to sufficiently approximate the impulse response, respectively the transfer function of an unknown system.

FIG. 3 illustrates in general the use of an adaptive filter. The unknown LRM system 4 is assumed to be a linear, distorting system whose transfer function is sought. To find the transfer function, an adaptive filter 10 is connected in parallel to the unknown LRM system 4. The signal r[k] distorted by the unknown system 4 is used here as a reference signal. The output f[k] of the adaptive filter 10 is subtracted from the reference signal to generate an error signal e[k]. Using, for example, the Least Mean Square (LMS) method, the filter coefficients of the adaptive filter 10 are set by iteration in such a way that the error signal e[k] becomes as small as possible, which causes f[k] to approach r[k]. Precisely speaking, a norm ($L^2$-norm) of the error signal e[k] is minimized. The unknown LRM system 4 and therefore its transfer function and respectively its impulse response are approximated by the adaptive filter 10 as a result. Due to the adaptation process the impulse response of the adaptive filter converges to the actual impulse response of the unknown LRM system 4.

The system and the method described in the following sections with reference to FIGs. 4 to 7 employ an adaptive filter 10 that adapts the associated filter coefficients in accordance with the Least Mean Square (LMS) algorithm, also known as Minimum Mean Square Error (MMSE) method. The LMS algorithm is based on the method of the steepest descent (falling gradient method) which estimates the gradient in a simple manner. In the examples of the invention, the algorithm works with time recursion; in other words, the algorithm is restarted for each new data set, and the solution is updated. The LMS algorithm is employed for adaptive filters and adaptive control systems in view of its low degree of complexity, numerical stability, and small memory requirements.

The system shown in FIG. 4 comprises a loudspeaker 2 as an acoustic transmitter, and a microphone 3 as an acoustic receiver, both disposed in a strongly reflective room thus forming a Loudspeaker-Room-Microphone (LRM) system 4 for reproducing a forward signal s[k] from a signal source 5 as well as for recording and analyzing the sound in the strongly reflective room. The sound received by a microphone 3 represent a superposition of the forward signal s[k] filtered by the system representing the room, reflections (i.e. echoes) thereof, and (uncorrelated) noise from a noise source 1. A respective measuring signal r[k] is generated by the acoustic receiver, i.e. microphone 3.

In the example of FIG. 4, the impulse response estimation unit IR is illustrated in more detail. It comprises an adder/subtractor 12 and an adaptive filter 10 having a filter unit 10a and an adaptation unit 10b. The estimation unit IR is coupled to the signal source 5 for receiving the forward signal s[k] and coupled to the microphone 3 for receiving the measuring signal r[k].

The impulse response $g_n[k]$ of the filter unit 10a is an estimation of the actual impulse response $h_n[k]$ of the LRM system 4 and is routed to a delay time calculation unit 15 (cf. FIG. 1) that is configured to calculate the desired propagation delay therefrom, as soon as the impulse response $g_n[k]$ is considered to be a valid estimation. That is, the propagation delay is calculated from the estimated impulse response $g_n[k]$, that is from the time of the sample that for the first time exceeds a threshold level TH1 as explained with reference to FIG. 1 and FIG. 2.

The filter unit 10a may be, for example, implemented as a Finite Impulse Response (FIR) filter with variable (i.e. time-variant) filter coefficients $b_0[k]$, $b_1[k]$, ..., $b_{N-1}[k]$, which describe the impulse response $b_n[k]$ of the FIR filter. The filter unit 10a receives at its input the forward signal s[k] and provides a filtered signal f[k] at its output. The filtered signal f[k] and the forward signal s[k] are related as follows:

$$f[k] = b_0 \cdot s[k] + b_1 \cdot s[k-1] + ... + b_{N-1} \cdot s[k-N-1]. \qquad (1)$$

The time variance of the adaptive filter coefficients is expressed by $b_n[k]$ ($n \in \{0, ..., N-1\}$) instead of solely $b_n$. The filtered signal f[k] and the measuring signal r[k] are supplied to the subtractor 12 that is configured to provide an error signal e[k]. Such an error signal represents the deviation of the filtered signal f[k] from the measuring signal r[k], that is:

$$e[k] = r[k] - f[k]. \qquad (2)$$

The adaptation unit 10b is configured to calculate the filter coefficients $b_0$ to $b_{N-1}$ such that the error signal e[k] (the norm of the error signal) becomes minimal. For this minimization task a Minimum Mean Square Error (MMSE or LMS) algorithm is employed. The forward signal s[k] and the error signal e[k] are supplied to the adaptation unit 10b for this purpose. Several (iterative) adaptation steps are performed. The adaptation unit 10b supplies an updated set of filter coefficients $b_0[k]$, $b_1[k]$, ..., $b_{N-1}[k]$ to the filter unit 10a in each adaptation step.

The iteration may be continued and the delay calculation should be done when a certain stop criterion is met. Therefore, a system distance D[k] or a mean value thereof may be calculated that indicates the quality of the approximation of the actual impulse response of the LRM system by the impulse response of the adaptive filter 10. If the system distance D[k] or its mean value falls below a distance threshold level TH2, the approximation is regarded as sufficiently good and the respective impulse response $b_n[k]$ of the adaptive filter 10, is regarded as a valid estimation $g_n[k]$ of the actual impulse response $h_n[k]$ of the LRM system. In mathematical terms:

$$g_n[k] = b_n[k] \qquad \text{if } D[k] < TH2, \qquad\qquad (3)$$
$$h_n[k] \approx g_n[k].$$

The decision whether the system distance $D[k]$ is below the distance threshold may be performed within the delay time calculation unit 15. The impulse response $b_n[k]$ as well as the system distance $D[k]$ is therefore routed to the delay time calculation unit 15. The propagation delay time value calculated from the estimated impulse response $g_n[k]$ = $b_n[k]$ is valid if the system distance $D[k]$ is lower than the distance threshold level TH2.

A certain delay time is inherent to the LRM system. Consequently, the first samples (occurring within the delay time) of the impulse response of the LRM system have to be zero as well. Assuming that the initial $N_t$ samples of the impulse response of the (ideal) LRM system are zero, the magnitude of the initial $N_t$ samples of the impulse response $b_n[k]$ of the adaptive filter 10 may be used as a measure of the quality of the approximation, i.e. as a measure for the "distance" $D[k]$ between the impulse response $b_n[k]$ of the adaptive filter 10 and the ideal impulse response of the LRM system $h_n[k]$. For example, the distance function may calculate as follows from the impulse response $b_n[k]$:

$$D[k] = (|b_0[k]| + |b_1[k]| + \ldots + |b_{Nt-1}[k]|)/N_t. \qquad (4)$$

The calculation of the distance function may also be performed by the time delay calculation unit 15 or by the adaptation unit 10b of the adaptive filter 10.

If the distance between the acoustic transmitter 2 and the acoustic receiver 3 is short (or unknown), the "intrinsic" propagation delay is short, too, and it could be difficult to calculate a reliable system distance $D[k]$ since only a few samples occur within the delay time of the LRM system.

In order to obtain enough samples for calculating the system distance $D[k]$ an additional delay time can be incorporated into the LRM system by connecting a delay line with an a priori known delay of $N_t$ samples downstream to the acoustic receiver 3. As a result, the total delay time of the LRM system is increased by $N_t$ samples. $N_t$ is chosen such that enough samples are available for calculating the system distance $D[k]$. For example, $N_t$ is within a range from 5 to 20 samples.

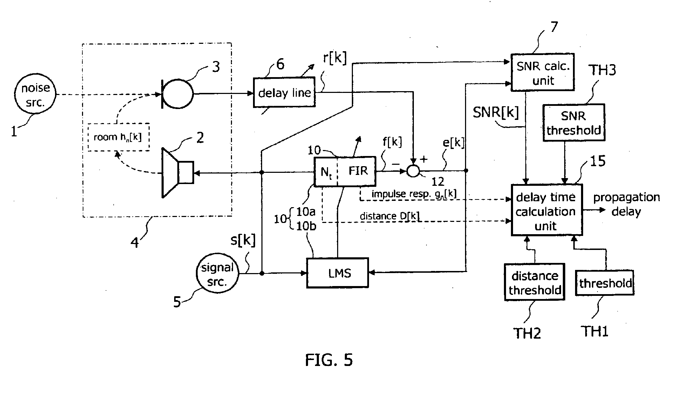

The system depicted in FIG. 5 comprises all features of the system of FIG. 4 and, additionally, a delay line 6 connected downstream of the acoustic transducer thus increasing the effective delay time of the LRM system. The delay of the delay line 6 has to be considered when calculating the actual propagation delay, i.e. the delay of the delay line 6 has to be subtracted from the delay obtained from the impulse response $b_n[k]$ as explained with reference to FIG. 2.

If strong noise occurs during the adaptation process, for example, due to a sudden change in the transfer characteristic of the LRM system, the change affects all filter coefficients $b_0[k]$, ..., $b_{N-1}[k]$ of the adaptive filter through the LMS algorithm. In particular, the filter coefficients $b_0$ to $b_{Nt-1}$, which are supposed to approach zero for a small system distance, are changed resulting in a value change in the system distance $D[k]$. As a consequence, any change to the adaptation process caused by noise of this kind results in an increase of the magnitude of the filter coefficients $b_0$ to $b_{Nt-1}$, and the system distance $D[k]$ is increased.

As a result, the adaptation process is extended and maintained until the adaptive filter sufficiently approximates the new status and the stop criterion is safely satisfied. In the environment described, noise of this kind that causes a change in the transfer function of the LRM system of a strongly reflective room could be, for example, due to the opening of a window or sliding roof in the passenger space of a vehicle. In such cases, the level and frequency spectrum of the noise signal also change, leading to an altered signal-to-noise ratio $SNR[k]$ of the measuring signal $r[k]$.

In order to cope with changes of the signal-to-noise ratio $SNR[k]$ of the measuring signal $r[k]$ the distance threshold level TH2 may be weighted with (or modified dependent on) an estimated signal-to-noise ratio $SNR[k]$ of the measuring signal $r[k]$. Furthermore, a SNR threshold TH3 may be defined, where $SNR[k]$ has to exceed the SNR threshold TH3 for a valid estimation of the desired impulse response. Similar to eqn. 3 this can be mathematically expressed as

$$g_n[k] = b_i[k] \qquad \text{for } i = N_t+1, \ldots, N-1,$$
$$\qquad\qquad \text{if } (D[k] < TH2) \text{ and } (SNR[k] > TH3), \qquad (5)$$
$$h_n[k] \approx g_n[k].$$

In contrast to eqn. 3, the first $N_t$ samples of the impulse response $b_n[k]$ of the adaptive filter 10 are not considered in the estimation $g_n[k]$ since in the present example of the invention the first $N_t$ samples have been introduced by the delay line 6 and are not part of the LRM system $h_n[k]$. An SNR calculation unit 7 ensures in this way that the measurement method responds robustly and flexibly, even if noise is experienced during active measurement, and that the desired adaptation quality is always obtained in compliance with the specified threshold values. For calculating the SNR the SNR[k] calculation unit 7 may receive the forward signal s[k] and the error signal e[k] as an approximation of the noise signal to calculate (i.e. estimate) the SNR[k] therefrom. The estimated SNR value is supplied to the delay time calculation unit 15 for being considered in the above-mentioned stop criterion for the propagation delay calculation.

One example of the method for determining the delay time at a time defined by time index k may be summarized as follows:

(A) Generate a forward signal s[k] and an acoustic signal dependent therefrom, the acoustic signal being radiated into a room by a loudspeaker receiving the forward signal;

(B) Use a microphone disposed in the room for providing a measuring signal r[k] representing a superposition of the acoustic signal, echoes thereof and noise, wherein the measuring signal r[k] is additionally delayed by means of a delay line that provides a delay of $N_t$ samples;

(C) Filtering the forward signal s[k] with a FIR filter having the initial impulse response (filter coefficients) $b_n[0] = [b_0[0], b_1[0], ..., b_{N-1}[0]]$, thus providing a filtered forward signal f[k];

(D) Calculate an error signal e[k] from the filtered forward signal f[k] and the measuring signal r[k] (cf. eqn. 2) ;

(E) Calculate an updated impulse response $b_n[k] = [b_0[k], b_1[k], ..., b_{N-1}[k]]$ of the FIR filter, such that the error signal e[k] is minimal by employing a minimum mean square algorithm. The updated impulse response $b_n[k+1]$ of the adaptive filter 10 may be calculated as follows:

$$b_n[k+1] = e[k] \cdot (b_n[k] \bullet S_n[k]) \qquad (6),$$

where $S_n[k]$ is a vector containing the latest N samples of the forward signal, i.e. $S_n[k] = (s[k], s[k-1], ..., s[k-n], ..., s[k-N+1])$, and the multiplication $b_n[k] \bullet S_n[k]$ is done element per element, i.e. $b_n[k] \bullet S_n[k] = (b_0[k] \bullet S_0[k], ..., b_{N-1}[k] \bullet S_{N-1}[k])$. However, other possibilities exist for implementing the LMS algorithm and thus for calculating the updated impulse response $b_n[k+1]$.

(F) Calculate system distance D[k] from the first $N_t$ samples of the impulse response $b_n[k]$ (cf. eqn. 4);

(G) Calculate SNR[k] from the forward signal f[k] and the error signal e[k] which is used as an approximation for the noise present in the measuring signal r[k];

(H) If the system distance D[k] is lower than a distance threshold TH2 and if signal-to-noise ratio SNR[k] is greater than a SNR threshold TH3, then the actual impulse response of the adaptive filter is regarded as a valid estimation (cf. eqn. 5) of the real impulse response $h_n[k]$ of the loudspeaker-room-microphone system, else repeat steps A to H with the updated impulse response $b_n[k+1]$ (cf. eqn. 6) in step C;

(I) Search for the maximum $g_{max}$ in the absolute estimated LRM impulse response $|g_n[k]|$ and set a first threshold TH1 to a fraction (e.g. 5%) thereof;

(J) Determine the number $n_1$ of the sample of the estimated LRM impulse response $g_n[k]$ whose absolute value $|g_{n1}[k]|$ exceeds the first threshold TH1 for the first time;

(K) Convert sample number $n_1$ to a delay time value $t_1$ dependent on the sample rate.

(J) Convert delay time value $t_1$ to a distance dependent on the speed of sound.

An updated filter impulse response $b_n[k]$ is calculated at every sample. However, it would be possible to only calculate an updated filter impulse response $b_n[k]$ every $p^{th}$ sample (p>1) but this would inevitably lead to undesirable peaks in the processor load of the digital signal processor performing all the calculations. Peak processor loads can also be avoided when performing the adaptation with a reduced sample rate, which in turn would lead to a slower adaptation.

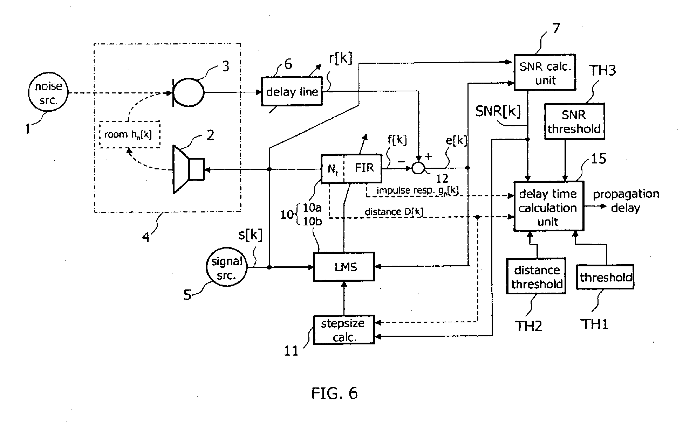

The systems of FIGs 4 and 5 use a fixed step-size in the adaptation process performed by the adaptation unit 10b. The system depicted in FIG. 6 is essentially equal to the system of FIG. 5 with the only difference that the impulse response estimation unit (cf. reference symbol IR in FIG.1) comprises a step-size calculation unit 11 connected to the adaptation unit 10b of the adaptive (FIR) filter 10. A variable step-size $\mu[k]$ is especially useful to make the whole adaptation process more robust and therefore faster against disturbances (noise or impulsive disturbances) which could corrupt a suitably estimated impulse response $b_n[k]$. The stop criterion is reached faster if the step-size $\mu[k]$ is adjusted dependent on the present system distance D[k] and the momentary signal-to-noise ratio SNR[k] value.

By means of this dynamic step-size adjustment the step-size may be reduced for retarding (slowing down) the adaptation or the adaptation may even be stopped in response to a sudden disturbance like an increase of the noise level or a sudden change in the impulse response of the room (i.e. an abrupt change of the LRM system). Using a filter with a fixed adaptation step-size the approximation obtained before the sudden disturbance would inevitably be destroyed. If the approximation is disturbed in a cyclic manner the stop criterion would never be reached and the adaptation would proceed ad infinitum without yielding an acceptable result. With a dynamic step-size adjustment the (well approximated) state of the present impulse response $b_n[k]$ of the adaptive filter 10 could be maintained until the disturbances have disappeared. Then, the approximation may be continued and an adequate approximation may be achieved between (cyclically) recurring disturbances.

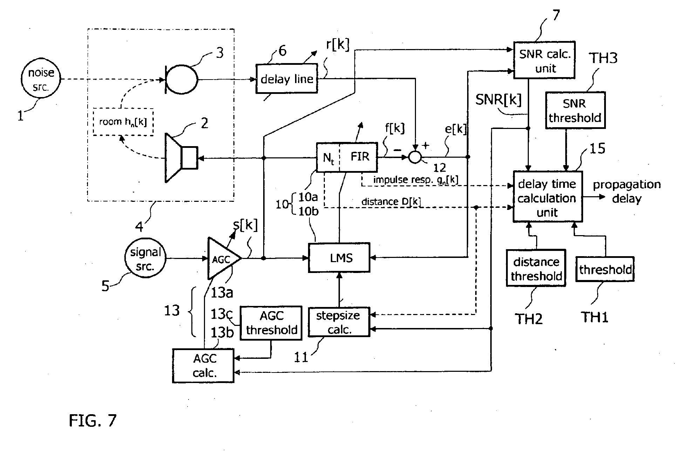

The system shown in FIG. 7 is essentially the same as the system of FIG. 6 with the difference that it also comprises an Automatic Gain Control (AGC) unit 13. This AGC unit 13 comprises a variable gain amplifier 13a and a gain calculation unit 13b that is configured to calculate a gain for the variable gain amplifier 13a dependent on the signal-to-noise ratio SNR[k] provided by the SNR calculation unit 7. However, the AGC unit 13 is connected downstream of the signal source 5 for amplifying the forward signal s[k] radiated from the loudspeaker 2. Thus, the amplitude of the acoustic signal incident on the microphone 3 is adjusted to a level which is high enough to yield a sufficient SNR of the respective measuring signal generated by the microphone 3. In case the amplifier would be inserted into signal path downstream of the microphone 3, noise present at the microphone 3 would be undesirably amplified, too. So only the forward signal is amplified dependent on the signal-to-noise ratio SNR[k] such that a sufficiently low SNR is achieved at the output of the microphone 3. The AGC unit 13 is controlled by an AGC threshold value that defines the aforementioned sufficiently low SNR ratio.

The systems (cf. FIGs 1 and 4 to 7) outlined above require little computing effort when implemented in a DSP, and enable control and adaptation of the quality of the impulse response to be determined in the active measurement through simple modifications of the measurement parameters, some of which are automated, while at the same time excluding the problems stated earlier. This is accomplished by employing an adaptive finite impulse response filter (FIR filter) with automatic amplification control of the measurement signal and introduction of a system with a known transfer function onto the microphone path. The advantageous effects are also derived from the introduction of a system with a known transfer function into the microphone path, which together with the unknown transfer system of the strongly reflective measurement environment is reproduced by an adaptive FIR filter, thereby enabling control of the quality of the impulse response and control of the success of the adaptation performed.

The effect is employed that the degree of the achieved quality of the impulse response to be determined for the whole system, comprising the unknown transfer function of the reflecting room and the known transfer function of the system on the microphone path, can be controlled by the success of the adaptation of the FIR filter to the system with the known transfer function.

Although examples of the present invention have been described herein in detail, it is desired, to emphasis that this has been for the purpose of illustrating the present invention and should not be considered as necessarily limitative of the invention, it is being understood that many modifications and variations can be made by those skilled in the art while still practising the invention claimed herein.

## Claims

**1.**    A system for measuring the acoustic propagation delay from an acoustic transmitter (2) to an acoustic receiver (3) which form a transmitter-room-receiver system (4), the system comprising:

a signal source (5) coupled to the acoustic transmitter (2) for supplying a forward signal (s[k]) thereto, the acoustic transmitter (2) emitting an acoustic signal;
an impulse response calculation unit (IR) configured to estimate the impulse response ($g_n[k]$) of the transmitter-room-receiver system (4) from a measuring signal (r[k]) provided by the acoustic receiver (3) and from the forward signal (s[k]), the measuring signal (r[k]) representing a superposition of the acoustic signal, echoes thereof and noise; and
a delay time calculation unit (15) coupled to the impulse response calculation unit (5) and configured to calculate the acoustic propagation delay from the estimated impulse response ($g_n[k]$),

**characterized in that** the acoustic propagation delay being calculated as the time ($t_1$) when the impulse response exceeds a threshold (TH1) for the first time.

2. The system of claim 1, where the impulse response calculation unit (IR) comprises an adaptive filter (10a, 10b), that is coupled to the signal source (5) for receiving the forward signal ($s[k]$) therefrom;
comprises an adaptive filter characteristic being controlled dependent on an error signal $e[k]$ and on the forward signal ($s[k]$); and
is configured to receive the error signal ($e[k]$) and to provide a filtered forward ($f[k]$) signal, the error signal depending on the measuring signal ($r[k]$) and the filtered forward signal ($f[k]$).

3. The system of claim 2 further comprising a delay line (6) that is coupled to the acoustic receiver receiving the measuring signal ($r[k]$) therefrom and supplying a delayed measuring signal ($r'[k]$) to the impulse response calculation unit (IR).

4. The system of claim 2 or 3 further comprising a signal-to-noise ratio calculation unit (7) configured to calculate a signal-to-noise ratio ($SNR[k]$) from the forward signal ($s[k]$) and the error signal ($e[k]$), the signal-to-noise ratio ($SNR[k]$) being supplied to the delay time calculation unit (15).

5. The system of claim 4, where the impulse response calculation unit (IR) further comprises a step-size calculation unit (11) receiving the signal-to-noise ratio ($SNR[k]$) and being configured to calculate an adaptation step-size ($\mu[k]$) that controls the adaptation speed of the adaptive filter (10a, 10b).

6. The system of claim 4 or 5 further comprising an automatic gain control unit (13a, 13b, 13c) being connected downstream of the signal source (5), comprising an amplifier (13a) with a variable gain for amplifying the forward signal ($s[k]$), and being configured to adjust the variable gain dependent on the signal-to-noise ratio ($SNR[k]$).

7. The system of one of claims 2 to 6, where the adaptive filter (10a, 10b) provides a system distance ($D[k]$) that is supplied to the delay time calculation unit (15).

8. The system of claim 7, where the delay time calculation unit (15) is supplied with a mean value of the system distance ($D[k]$).

9. The system of claim 8, where the delay time calculation unit (15) is configured to calculate the propagation delay from the impulse response ($g_n[k]$) if the mean value of the system distance ($D[k]$) falls below a distance threshold level (TH2).

10. The system of one of claims 2 to 9, where the adaptive filter (10a, 10b) is an Finite Impulse Response filter with adaptive filter coefficients ($b[k]$) which determine the filter characteristic.

11. The system of claim 10, where the adaptive filter (10a, 10b) comprises a Least-Mean-Square calculation unit (10b) being configured to calculate the filter coefficients ($b_n[k]$) according to the Least Mean Square algorithm from the error signal ($e[k]$)and the forward signal ($s[k]$).

12. The system of one of the claims 1 to 11, further comprising:

a distance calculation unit configured to calculate the distance between the acoustic transmitter (2) and the acoustic receiver (3) from the acoustic propagation delay and the speed of sound.

13. A method for measuring the acoustic propagation delay from an acoustic transmitter (2) to an acoustic receiver (3) which form a transmitter-room-receiver system (4), the method comprising the steps of:

providing a forward signal ($s[k]$) to the acoustic transmitter (2) thus radiating an acoustic signal;
generating a measuring signal ($r[k]$) by the acoustic receiver (3), the measuring signal ($r[k]$) representing a superposition of the acoustic signal, echoes thereof and noise;
estimating an impulse response ($g_n[k]$) of the transmitter-room-receiver system (4) from the measuring signal ($r[k]$) and from the forward signal ($s[k]$); and

calculating the propagation delay from the estimated impulse response ($g_n[k]$),

**characterized in that** the propagation delay is calculated as the time ($t_1$) when the impulse response exceeds a threshold (TH1) for the first time.

14. The method of claim 13, further comprising the steps of:

adaptive filtering the forward signal ($s[k]$) with an adaptive filter characteristic thus providing a filtered forward signal ($f[k]$);
calculating an error signal ($e[k]$) dependent on the measuring ($r[k]$) signal and the filtered forward ($f[k]$) signal;
modifying the adaptive filter characteristic dependent on the error signal ($e[k]$) and on the forward signal ($s[k]$), the adaptive filter characteristic representing the estimated impulse response of the transmitter-room-receiver system (4).

15. The method of claim 14 further comprising the step of delaying the measuring signal ($r[k]$) generated by the acoustic receiver (3) before further processing of the measuring signal ($r[k]$).

16. The method of claim 14 or 15 further comprising the step of calculating a signal-to-noise ratio ($SNR[k]$) from the forward signal ($s[k]$) and the error signal ($e[k]$).

17. The method of claim 16 further comprising the step of calculating an adaptation step-size ($\mu[k]$) that controls the adaptation speed of the adaptable filter characteristic.

18. The method of claim 16 or 17 further comprising the steps of adjusting a variable gain dependent on the signal-to-noise ratio ($SNR[k]$); amplifying the forward signal ($s[k]$) by the variable gain before further processing of the forward signal ($s[k]$).

19. The method of claim 18, where the variable gain is calculated from the signal-to noise ratio ($SNR[k]$).

20. The method of one of claims 14 to 19 comprising the step of calculating a system distance ($D[k]$) representing the deviation of the adaptive filter characteristic from a characteristic of the transmitter-room-receiver system (4).

21. The method of claim 20, where a mean value of the system distance ($D[k]$) is used in the calculation of the propagation delay.

22. The method of claim 21, where the propagation delay is calculated from the impulse response ($g_n[k]$) if the mean value of the system distance ($D[k]$) falls beyond a distance threshold level (TH2).

23. The method of one of claims 14 to 22, where an Finite Impulse Response filter with adaptive filter coefficients ($b[k]$) is used for adaptive filtering, the filter coefficients determining the adaptive filter characteristic.

24. The method of claim 23 comprising the step of calculating the filter coefficients ($b_n[k]$) of the Finite Impulse Response filter from the error signal ($e[k]$) and from the forward signal ($s[k]$) by employing a Least-Mean-Square algorithm.

25. The method of claim 18 where the variable gain is calculated such that the signal-to-noise ($SNR[k]$) ratio exceeds a minimum value.

26. The method of claim 18 where the variable gain is calculated such that the amplitude of the measurement signal ($r[k]$) exceeds a minimum amplitude.

**Patentansprüche**

1. System zum Messen der akustischen Ausbreitungsverzögerung von einem akustischen Sender (2) zu einem akustischen Empfänger (3), die ein Sender-Raum-Empfängersystem (4) bilden, wobei das System Folgendes umfasst:

eine Signalquelle (5), die an den akustischen Sender (2) gekoppelt ist, um ein Vorwärtssignal ($s[k]$) an ihn zu leiten, wobei der akustische Sender (2) ein akustisches Signal abgibt;

eine Impulsantwortberechnungseinheit (IR), die dazu konfiguriert ist, die Impulsantwort ($g_n[k]$) des Sender-Raum-Empfängersystems (4) anhand eines Messsignals ($r[k]$) zu berechnen, das von dem akustischen Empfänger (3) und von dem Vorwärtssignal ($s[k]$) bereitgestellt wird, wobei das Messsignal ($r[k]$) eine Überlagerung von dem akustischen Signal, von Echos davon und von Rauschen darstellt; und

eine Verzögerungsberechnungseinheit (15), die an die Impulsantwortberechnungseinheit (5) gekoppelt ist und dazu konfiguriert ist, die akustische Ausbreitungsverzögerung anhand der geschätzten Impulsantwort ($g_n[k]$) zu berechnen,

**dadurch gekennzeichnet, dass** die akustische Ausbreitungsverzögerung zu dem Zeitpunkt ($t_1$) berechnet wird, wenn die Impulsantwort erstmals einen Schwellenwert (TH1) überschreitet.

2. System nach Anspruch 1, wobei die Impulsantwortberechnungseinheit (IR) ein adaptives Filter (10a, 10b) umfasst, das

an die Signalquelle (5) gekoppelt ist, um das Vorwärtssignal ($s[k]$) davon zu empfangen; eine adaptive Filterkennlinie umfasst, die abhängig von einem Fehlersignal $e[k]$ und dem Vorwärtssignal ($s[k]$) gesteuert wird; und

dazu konfiguriert ist, das Fehlersignal ($e[k]$) zu empfangen und ein gefiltertes Vorwärtssignal ($f[k]$) bereitzustellen, wobei das Fehlersignal vom Messsignal ($r[k]$) und dem gefilterten Vorwärtssignal ($f[k]$) abhängig ist.

3. System nach Anspruch 2, ferner umfassend eine Verzögerungsleitung (6), die an den akustischen Empfänger gekoppelt ist, der das Messsignal ($r[k]$) davon empfängt, und ein verzögertes Messsignal ($r'[k]$) an die Impulsantwortberechnungseinheit (IR) leitet.

4. System nach Anspruch 2 oder 3, ferner umfassend eine Signal-Rausch-Verhältnis-Berechnungseinheit (7), die dazu konfiguriert ist, ein Signal-Rausch-Verhältnis ($SNR[k]$) aus dem Vorwärtssignal ($s[k]$) und dem Fehlersignal ($e[k]$) zu berechnen, wobei das Signal-Rausch-Verhältnis ($SNR[k]$) an die Verzögerungsberechnungseinheit (15) geleitet wird.

5. System nach Anspruch 4, wobei die Impulsantwortberechnungseinheit (IR) ferner eine Schrittgrößenberechnungseinheit (11) umfasst, die das Signal-Rausch-Verhältnis ($SNR[k]$) empfängt und dazu konfiguriert ist, eine Adaptationsschrittgröße ($\mu[k]$) zu berechnen, die die Adaptationsgeschwindigkeit des adaptiven Filters (10a, 10b) steuert.

6. System nach Anspruch 4 oder 5, ferner umfassend eine automatische Verstärkungssteuereinheit (13a, 13b, 13c), die nachgeschaltet zur Signalquelle (5) verbunden ist und einen Verstärker (13a) mit einer variablen Verstärkung zum Verstärken des Vorwärtssignal ($s[k]$) umfasst und dazu konfiguriert ist, eine variable Verstärkung abhängig von dem Signal-Rausch-Verhältnis ($SNR[k]$) anzupassen.

7. System nach einem der Ansprüche 2 bis 6, wobei das adaptive Filter (10a, 10b) einen Systemabstand ($D[k]$) bereitstellt, der an die Verzögerungsberechnungseinheit (15) geleitet wird.

8. System nach Anspruch 7, wobei die Verzögerungsberechnungseinheit (15) einen Mittelwert des Systemabstands ($D[k]$) erhält.

9. System nach Anspruch 8, wobei die Verzögerungsberechnungseinheit (15) dazu konfiguriert ist, die Ausbreitungsverzögerung aus der Impulsantwort ($g_n[k]$) zu berechnen, wenn der Mittelwert des Systemabstands ($D[k]$) unter einen Abstandsschwellenwert (TH2) fällt.

10. System nach einem der Ansprüche 2 bis 9, wobei das adaptive Filter (10a, 10b) ein Filter mit finiter Impulsantwort mit adaptiven Filterkoeffizienten ($b[k]$) ist, die die Filterkennlinie bestimmen.

11. System nach Anspruch 10, wobei das adaptive Filter (10a, 10b) eine Berechnungseinheit für die kleinsten mittleren Quadrate (10b) umfasst, die dazu konfiguriert ist, die Filterkoeffizienten ($b_n[k]$) gemäß dem Algorithmus für die kleinsten mittleren Quadrate anhand des Fehlersignals ($e[k]$) und des Vorwärtssignals ($s[k]$) zu berechnen.

12. System nach einem der Ansprüche 1 bis 11, ferner umfassend:

eine Abstandsberechnungseinheit, die dazu konfiguriert ist, den Abstand zwischen dem akustischen Sender (2) und dem akustischen Empfänger (3) anhand der akustischen Ausbreitungsverzögerung und der Schallgeschwindigkeit zu berechnen.

13. Verfahren zum Messen der akustischen Ausbreitungsverzögerung von einem akustischen Sender (2) an einen akustischen Empfänger (3), die ein Sender-Raum-Empfängersystem (4) bilden, wobei das Verfahren folgende Schritte umfasst:

Bereitstellen eines Vorwärtssignals (s[k]) an den akustischen Sender (2), wodurch ein akustisches Signal abgestrahlt wird;

Erzeugen eines Messsignals (r[k]) durch den akustischen Empfänger (3), wobei das Messsignal (r[k]) eine Überlagerung von dem akustischen Signal, von Echos davon und von Rauschen darstellt;

Schätzen einer Impulsantwort ($g_n[k]$) des Sender-Raum-Empfängersystems (4) anhand des Messsignals (r[k]) und anhand des Vorwärtssignals (s[k]); und

Berechnen der Ausbreitungsverzögerung anhand der geschätzten Impulsantwort ($g_n[k]$), **dadurch gekennzeichnet, dass** die Ausbreitungsverzögerung zu dem Zeitpunkt ($t_1$) berechnet wird, wenn die Impulsantwort erstmals einen Schwellenwert (TH1) überschreitet.

14. Verfahren nach Anspruch 13, ferner folgende Schritte umfassend:

adaptives Filtern des Vorwärtssignals (s[k]) mit einer adaptive Filterkennlinie, wodurch ein gefiltertes Vorwärtssignal (f[k]) bereitgestellt wird;

Berechnen eines Fehlersignals (e[k]) abhängig vom Messsignal (r[k]) und dem gefilterten Vorwärtssignal (f[k]);

Modifizieren der adaptiven Filterkennlinie abhängig von dem Fehlersignal (e[k]) und dem Vorwärtssignal (s[k]), wobei die adaptive Filterkennlinie die geschätzte Impulsantwort des Sender-Raum-Empfängersystems (4) darstellt.

15. Verfahren nach Anspruch 14, ferner umfassend den Schritt des Verzögerns des Messsignals (r[k]), das von dem akustischen Empfänger (3) erzeugt wird, vor einer weiteren Verarbeitung des Messsignals (r[k]).

16. Verfahren nach Anspruch 14 oder 15, ferner umfassend den Schritt des Berechnens eines Signal-Rausch-Verhältnisses (SNR[k]) anhand des Vorwärtssignals (s[k]) und des Fehlersignals (e[k]).

17. Verfahren nach Anspruch 16, ferner umfassend den Schritt des Berechnens einer Adaptationsschrittgröße ($\mu[k]$), die die Adaptationsgeschwindigkeit der adaptierbaren Filterkennlinie steuert.

18. Verfahren nach Anspruch 16 oder 17, ferner umfassend die Schritte:

Anpassen einer variablen Verstärkung abhängig vom Signal-Rausch-Verhältnis (SNR[k]);

Verstärken des Vorwärtssignals (s[k]) durch die variable Verstärkung vor einer weiteren Verarbeitung des Vorwärtssignals (s[k]).

19. Verfahren nach Anspruch 18, wobei die variable Verstärkung anhand des Signal-Rausch-Verhältnisses (SNR[k]) berechnet wird.

20. Verfahren nach einem der Ansprüche 14 bis 19, umfassend den Schritt des Berechnens eines Systemabstands (D[k]), der die Abweichung der adaptiven Filterkennlinie von einer Kennlinie des Sender-Raum-Empfängersystems (4) darstellt.

21. Verfahren nach Anspruch 20, wobei ein Mittelwert des Systemabstands (D[k]) bei der Berechnung der Ausbreitungsverzögerung verwendet wird.

22. Verfahren nach Anspruch 21, wobei die Ausbreitungsverzögerung anhand der Impulsantwort ($g_n[k]$) berechnet wird, wenn der Mittelwert des Systemabstands (D[k]) in einen Bereich jenseits von einem Abstandsschwellenwert (TH2) fällt.

23. Verfahren nach einem der Ansprüche 14 bis 22, wobei ein Filter mit finiter Impulsantwort mit adaptiven Filterkoeffizienten (b[k]) zum adaptiven Filtern verwendet wird, wobei die Filterkoeffizienten die adaptive Filterkennlinie bestimmen.

24. Verfahren nach Anspruch 23, folgenden Schritt umfassend Berechnen der Filterkoeffizienten ($b_n[k]$) des Filters mit finiter Impulsantwort anhand des Fehlersignals (e[k]) und des Vorwärtssignals (s[k]) durch Verwenden eines Algorithmus der kleinsten mittleren Quadrate.

**25.** Verfahren nach Anspruch 18, wobei die variable Verstärkung derart berechnet wird, dass das Signal-Rausch-Verhältnis (SNR[k]) einen Mindestwert übersteigt.

**26.** Verfahren nach Anspruch 18, wobei die variable Verstärkung derart berechnet wird, dass die Amplitude des Messsignals (r[k]) eine Mindestamplitude übersteigt.

**Revendications**

**1.** Système de mesure du délai de propagation acoustique d'un émetteur acoustique (2) à un récepteur acoustique (3) qui forment un système d'émetteur-récepteur de salle (4), le système comprenant :

une source de signal (5) couplée à l'émetteur acoustique (2) pour fournir un signal vers l'avant (s[k]) à celui-ci, l'émetteur acoustique (2) émettant un signal acoustique ;
une unité de calcul de réponse impulsionnelle (IR) configurée pour estimer la réponse impulsionnelle ($g_n$[k]) du système d'émetteur-récepteur de salle (4) à partir d'un signal de mesure (r[k]) fourni par le récepteur acoustique (3) et à partir du signal vers l'avant (s[k]), le signal de mesure (r[k]) représentant une superposition du signal acoustique, des échos de celui-ci et du bruit ; et
une unité de calcul du délai de temporisation (15) couplée à l'unité de calcul de réponse impulsionnelle (5) et configurée pour calculer le délai de propagation acoustique à partir de la réponse impulsionnelle estimée ($g_n$[k]),

**caractérisé en ce que** le délai de propagation acoustique est calculé comme étant le temps ($t_1$) lorsque la réponse impulsionnelle excède un seuil (TH1) pour le premier temps.

**2.** Système selon la revendication 1, où l'unité de calcul de réponse impulsionnelle (IR) comprend un filtre adaptatif (10a, 10b) qui
est couplé à la source de signal (5) pour la réception du signal vers l'avant (s[k]) de celle-ci ;
comprend une caractéristique de filtre adaptatif commandée selon un signal d'erreur e[k] et le signal vers l'avant (s[k]) ; et
est configuré pour recevoir le signal d'erreur (e[k]) et pour fournir un signal vers l'avant filtré (f[k]), le signal d'erreur dépendant du signal de mesure (r[k]) et du signal vers l'avant filtré (f[k]).

**3.** Système selon la revendication 2, comprenant en outre une ligne de retard (6) qui est couplée au récepteur acoustique recevant le signal de mesure (r[k]) de celui-ci et fournissant un signal de mesure retardé (r'[k]) à l'unité de calcul de réponse impulsionnelle (IR).

**4.** Système selon la revendication 2 ou 3, comprenant en outre une unité de calcul de rapport signal/bruit (7) configurée pour calculer un rapport signal/bruit (SNR[k]) à partir du signal vers l'avant (s[k]) et du signal d'erreur (e[k]), le rapport signal/bruit (SNR[k]) étant fourni à l'unité de calcul du délai de temporisation (15).

**5.** Système selon la revendication 4, où l'unité de calcul de réponse impulsionnelle (IR) comprend en outre une unité de calcul de pas (11) recevant le rapport signal/bruit (SNR[k]) et étant configurée pour calculer un pas d'adaptation ($\mu$[k]) qui commande la vitesse d'adaptation du filtre adaptatif (10a, 10b).

**6.** Système selon la revendication 4 ou 5, comprenant en outre une unité de commande de gain automatique (13a, 13b, 13c) reliée en aval de la source de signal (5), comprenant un amplificateur (13a) avec un gain variable pour l'amplification du signal vers l'avant (s[k]) et configurée pour ajuster le gain variable selon le rapport signal/bruit (SNR[k]).

**7.** Système selon l'une quelconque des revendications 2 à 6, où le filtre adaptatif (10a, 10b) fournit une distance de système (D[k]) qui est transmise à l'unité de calcul de délai de temporisation (15).

**8.** Système selon la revendication 7, où l'unité de calcul de délai de temporisation (15) est dotée d'une valeur moyenne de la distance de système (D[k]).

**9.** Système selon la revendication 8, où l'unité de calcul de délai de temporisation (15) est configurée pour calculer le délai de propagation à partir de la réponse impulsionnelle ($g_n[k]$) si la valeur moyenne de la distance de système (D[k]) tombe sous un niveau seuil de distance (TH2).

**10.** Système selon l'une quelconque des revendications 2 à 9, où le filtre adaptatif (10a, 10b) est un filtre à réponse impulsionnelle finie avec des coefficients de filtre adaptatif (b[k]) qui déterminent la caractéristique de filtre.

**11.** Système selon la revendication 10, où le filtre adaptatif (10a, 10b) comprend une unité de calcul du moindre carré moyen (10b) configurée pour calculer les coefficients de filtre ($b_n[k]$) selon l'algorithme du moindre carré moyen à partir du signal d'erreur (e[k]) et du signal vers l'avant (s[k]).

**12.** Système selon l'une quelconque des revendications 1 à 11, comprenant en outre :

une unité de calcul de distance configurée pour calculer la distance entre l'émetteur acoustique (2) et le récepteur acoustique (3) à partir du délai de propagation acoustique et de la vitesse du son.

**13.** Procédé de mesure du délai de propagation acoustique d'un émetteur acoustique (2) à un récepteur acoustique (3) qui forment un système d'émetteur-récepteur de salle (4), le procédé comprenant les étapes suivantes :

la fourniture d'un signal vers l'avant (s[k]) à l'émetteur acoustique (2) émettant ainsi un signal acoustique ;
la génération d'un signal de mesure (r[k]) par le récepteur acoustique (3), le signal de mesure (r[k]) représentant une superposition du signal acoustique, des échos de celui-ci et du bruit ;
l'estimation d'une réponse impulsionnelle ($g_n[k]$) du système d'émetteur-récepteur de salle (4) à partir du signal de mesure (r[k]) et du signal vers l'avant (s[k]) ; et
le calcul du délai de propagation de la réponse impulsionnelle estimée ($g_n[k]$), **caractérisé en ce que** le délai de propagation est calculé comme étant le temps ($t_1$) lorsque la réponse impulsionnelle excède un seuil (TH1) pour le premier temps.

**14.** Procédé selon la revendication 13, comprenant en outre les étapes suivantes :

le filtrage adaptatif du signal vers l'avant (s[k]) avec une caractéristique de filtre adaptatif fournissant ainsi un signal vers l'avant filtré (f[k]) ;
le calcul d'un signal d'erreur (e[k]) selon le signal de mesure (r[k]) et le signal vers l'avant filtré (f[k]) ;
la modification de la caractéristique de filtre adaptatif selon le signal d'erreur (e[k]) et le signal vers l'avant (s[k]), la caractéristique de filtre adaptatif représentant la réponse impulsionnelle estimée du système d'émetteur-récepteur de salle (4).

**15.** Procédé selon la revendication 14, comprenant en outre l'étape de temporisation du signal de mesure (r[k]) généré par le récepteur acoustique (3) avant de poursuivre le traitement du signal de mesure (r[k]).

**16.** Procédé selon la revendication 14 ou 15, comprenant en outre l'étape de calcul d'un rapport signal/bruit (SNR[k]) à partir du signal vers l'avant (s[k]) et du signal d'erreur (e[k]).

**17.** Procédé selon la revendication 16, comprenant en outre l'étape de calcul d'un pas d'adaptation ($\mu[k]$) qui commande la vitesse d'adaptation de la caractéristique de filtre adaptable.

**18.** Procédé selon la revendication 16 ou 17, comprenant en outre les étapes suivantes :

l'ajustement d'un gain variable selon le rapport signal/bruit (SNR[k]) ;
l'amplification du signal vers l'avant (s[k]) par le gain variable avant de poursuivre le traitement du signal vers l'avant (s[k]).

**19.** Procédé selon la revendication 18, où le gain variable est calculé à partir du rapport signal/bruit (SNR[k]).

**20.** Procédé selon l'une quelconque des revendications 14 à 19, comprenant l'étape de calcul d'une distance de système (D[k]) représentant la déviation de la caractéristique de filtre adaptatif d'une caractéristique du système d'émetteur-récepteur de salle (4).

**21.** Procédé selon la revendication 20, où une valeur moyenne de la distance de système (D[k]) est utilisée dans le calcul du délai de propagation.

**22.** Procédé selon la revendication 21, où le délai de propagation est calculé à partir de la réponse impulsionnelle ($g_n[k]$) si la valeur moyenne de la distance de système (D[k]) tombe au-delà d'un niveau seuil de distance (TH2).

**23.** Procédé selon l'une quelconque des revendications 14 à 22, où un filtre à réponse impulsionnelle finie avec des coefficients de filtre adaptatif (b[k]) est utilisé pour le filtrage adaptatif, les coefficients de filtre déterminant la caractéristique de filtre adaptatif.

**24.** Procédé selon la revendication 23, comprenant l'étape suivante :

le calcul des coefficients de filtre ($b_n[k]$) du filtre à réponse impulsionnelle finie à partir du signal d'erreur (e[k]) et du signal vers l'avant (s[k]) en employant un algorithme du moindre carré moyen.

**25.** Procédé selon la revendication 18, où le gain variable est calculé de sorte que le rapport signal/bruit (SNR[k]) excède une valeur minimale.

**26.** Procédé selon la revendication 18, où le gain variable est calculé de sorte que l'amplitude du signal de mesure (r[k]) excède une amplitude minimale.

FIG. 1

FIG. 2

FIG. 3

FIG. 4

FIG. 5

FIG. 6

FIG. 7

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2006014344 A2

- EP 1720249 A1